# EUROPÄISCHE PATENTANMELDUNG

(11) **EP 3 954 804 A1**
(43) Veröffentlichungstag der Anmeldung: **16.02.2022**
(21) Anmeldenummer: 20191166.6
(22) Anmeldetag: 14.08.2020
(51) Int. Cl.: C23C 16/44, C30B 25/08

(54) **VORRICHTUNG UND VERFAHREN ZUM ABSCHEIDEN EINER SCHICHT AUS HALBLEITERMATERIAL AUF EINER SUBSTRATSCHEIBE**

(71) Anmelder: Siltronic AG, 81677 München (DE)
(72) Erfinder: Hecht, Hannes, 84489 Burghausen (DE)
(74) Vertreter: Staudacher, Wolfgang

(57) **Zusammenfassung**

Vorrichtung zum Abscheiden einer Schicht aus Halbleitermaterial auf einer Substratscheibe, umfassend
einen Grundring zwischen einer oberen und einer unteren Kuppel; einen Suszeptor als Träger der Substratscheibe während des Abscheidens der Schicht;
einen Gaseinlass und einen Gasauslass, eine Abgasleitung sowie Gaszuleitungen zum Leiten von Prozessgas über eine obere Seitenfläche der Substratscheibe;
ein Schlitzventil-Tunnel und eine Schlitzventil-Türe; und
eine Hub- und Rotationseinrichtung zum Heben und Drehen des Suszeptors und der Substratscheibe,
dadurch gekennzeichnet, dass ein oder mehrere Bestandteile der Vorrichtung, die aus Edelstahl bestehen von einer amorphen Schicht bedeckt sind, die Silizium und Wasserstoff enthält.

## Beschreibung

Gegenstand der Erfindung ist eine Vorrichtung zum Abscheiden einer Schicht aus Halbleitermaterial auf einer Substratscheibe mittels Abscheidung aus der Gasphase. Gegenstand der Erfindung ist auch ein Verfahren, im Zuge dessen die Vorrichtung verwendet wird.

### Stand der Technik / Probleme

Anspruchsvolle Anwendungen auf dem Gebiet der Herstellung von Grundmaterial für die elektronische Industrie umfassen das Abscheiden einer Schicht aus Halbleitermaterial auf einer Substratscheibe, insbesondere das Abscheiden einer epitaktischen Schicht auf der Substratscheibe.

Während des Abscheidens der Schicht liegt die Substratscheibe mit Abscheidetemperatur auf einem Suszeptor. Prozessgas wird über die obere Seitenfläche der Substratscheibe geleitet, wobei Spaltprodukte einer darin enthaltenen chemischen Verbindung (precursor) als Materialschicht auf der Seitenfläche kristallisieren.

Vorrichtungen, wie beispielsweise der in US 2009 314 205 A1 beschriebene Einzelscheiben-Reaktor, sind für den genannten Zweck besonders geeignet. Er verfügt über einen Grundring, der zwischen einer oberen und einer unteren Kuppel angeordnet ist. Sie formen zusammen einen Reaktionsraum, der einen Suszeptor beherbergt, der die Substratscheibe während des Abscheidens der Schicht aus Halbleitermaterial trägt. Die Substratscheibe wird durch eine Schlitzventil-Türe und einen Schlitzventil-Tunnel in den Reaktionsraum transportiert. Das Prozessgas wird durch Gaszuleitungen von einem Gaseinlass zu einem Gasauslass geleitet. Die Substratscheibe wird mittels Wärmestrahlung auf Abscheidetemperatur gebracht.

Grundmaterial für die elektronische Industrie muss möglichst arm an Fremdstoffen sein, die die Funktion von elektronischen Bauelementen beeinträchtigen können.

Hierzu zählen insbesondere metallische Verunreinigungen. Um diesem Erfordernis auch unter den vorherrschenden Abscheidebedingungen wie der Abscheidetemperatur gerecht zu werden, bestehen Bestandteile der Vorrichtung wie der Grundring, der Gaseinlass, der Gasauslass, die Gaszuleitungen, die Abgasleitungen (inklusive Faltenbalg und Konus), die Schlitzventil-Türe und der Schlitzventil-Tunnel in der Regel aus Edelstahl.

Obwohl Edelstahl als besonders korrosionsfest gilt, ist es wünschenswert weitgehendst zu unterbinden, dass metallische Verunreinigungen wie Eisen vom Edelstahl in die Schicht aus Halbleitermaterial, die auf der Substratscheibe abgeschieden wird, gelangen kann.

Die Aufgabe der Erfindung wird gelöst durch eine Vorrichtung zum Abscheiden einer Schicht aus Halbleitermaterial auf einer Substratscheibe, umfassend
einen Grundring zwischen einer oberen und einer unteren Kuppel;
einen Suszeptor zum Tragen der Substratscheibe während des Abscheidens der Schicht;
einen Gaseinlass und einen Gasauslass sowie Gaszuleitungen zum Leiten von Prozessgas über eine obere Seitenfläche der Substratscheibe;
ein Schlitzventil-Tunnel und eine Schlitzventil-Türe; und
eine Hub- und Rotationseinrichtung zum Heben und Drehen des Suszeptors und der Substratscheibe,
dadurch gekennzeichnet, dass ein oder mehrere Bestandteile der Vorrichtung, die aus Edelstahl bestehen von einer amorphen Schicht bedeckt sind, die Silizium und Wasserstoff enthält.

Es wurde herausgefunden, dass bestimmte amorphe Beschichtungen für Edelstahl für den beabsichtigten Schutz der Substratscheibe mit abgeschiedener Schicht aus Halbleitermaterial vor Verunreinigungen besonders geeignet sind. Es sind Beschichtungen für Edelstahl, die selbst mittels thermisch induzierter chemischer Gasphasenabscheidung erzeugt werden und Silizium und Wasserstoff enthalten.

Vorzugsweise ist mindestens ein Bestandteil der Vorrichtung, der aus Edelstahl besteht mit der Beschichtung für Edelstahl beschichtet, zumindest auf einer Fläche, die dem Prozessgas während des Abscheidens der Schicht aus Halbleitermaterial auf der Substratscheibe ausgesetzt ist. Vorzugsweise ist mindestens ein Bestandteil wie der Grundring, der Gaseinlass, der Gasauslass, die Gaszuleitungen, die Schlitzventil-Türe, der Schlitzventil-Tunnel und die Hub- und Rotationseinheit zum Heben und Drehen eines Suszeptors und der Substratscheibe mit dieser Beschichtung beschichtet. Besonders bevorzugt ist es, wenn alle oder nahezu alle Bestandteile der Vorrichtung, die aus Edelstahl gefertigt sind und die mit Prozessgas unter den Abscheidebedingungen in Kontakt kommen, mit der Beschichtung für Edelstahl bedeckt sind.

Bei der Beschichtung handelt es sich vorzugsweise um hydrogenisiertes amorphes Silizium (a-Si:H) oder (a-SiₓC₁₋ₓ:H), besonders bevorzugt um eine funktionalisierte silica-artige Beschichtung (a-SiOₓ:CH_{y}). Eine Beschichtung von Edelstahl aus hydrogenisiertem amorphen Silizium wird beispielsweise unter der Marke Silicolloy^{®} von SilcoTek Corp. und unter der Marke SilCor^{®}SiC von PT&B SILCOR GmbH angeboten, und eine funktionalisierte silica-artige Beschichtung unter der Marke Dursan^{®} ebenfalls von SilcoTek Corp. Die Beschichtung des Edelstahls erfolgt vorzugsweise mittels CVD (chemical vapor deposition) oder PCVD (plasma activated CVD). Ein solches Verfahren zum Anbringen einer derartigen Beschichtung auf Edelstahl ist beispielsweise in EP 2 988 327 A1 beschrieben.

Gegenstand der Erfindung ist auch ein Verfahren zum Abscheiden einer epitaktischen Schicht aus Halbleitermaterial auf einer Substratscheibe, wobei die Substratscheibe in einer Vorrichtung mit der epitaktischen Schicht beschichtet wird, die die vorstehend beschriebenen Eigenschaften hat.

Die Substratscheibe ist vorzugsweise eine Halbleiterscheibe aus einkristallinem Silizium, auf der eine Schicht aus einkristallinem Silizium unter Normaldruck epitaktisch abgeschieden wird. Die Abscheidetemperatur beträgt vorzugsweise 1000 °C bis 1300 °C. Die Substratscheibe und/oder die epitaktische Schicht können mit einem elektrisch aktiven Dotierstoff dotiert sein. Der Dotierstoff-Typ (p-Typ, n-Typ) kann gleich oder unterschiedlich sein. Die Substratscheibe hat vorzugsweise einen Durchmesser von mindestens 200 mm, besonders bevorzugt von mindestens 300 mm.

In der nachfolgenden Beschreibung wird auf Zeichnungen Bezug genommen.
Fig. 1 zeigt einige Merkmale der Vorrichtung, mit denen sich die Erfindung beschäftigt in Schnittdarstellung.
Fig. 2 zeigt die Ergebnisse von Lebensdauermessungen von Minoritätsladungsträgern mittels µPCD-Messung (microwave photoconductivity decay).

### Symbolliste:

- 1: obere Kuppel
- 2: untere Kuppel
- 3: Vorrichtung
- 4: Substratscheibe
- 5: Suszeptor
- 6: Lampen
- 7: Grundring
- 8: Gaseinlass für Prozessgas
- 9: Gaseinlass für Spülgas
- 10: Gasauslass für Prozessgas
- 11: Gasauslass für Spülgas
- µPCD: Lebensdauer-Werte gemessen mittels µPCD-Messung
- N: Anzahl der gemessenen Substratscheiben mit abgeschiedener epitaktischer Schicht

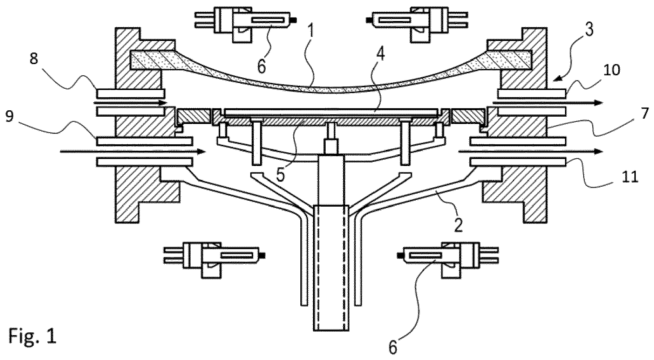

Fig. 1 zeigt einige Merkmale der Vorrichtung, mit denen sich die Erfindung beschäftigt in Schnittdarstellung. Die Vorrichtung 3 umfasst einen Grundring 7, eine obere und eine untere Kuppel 1, 2. Über der oberen Kuppel 1 und unter der unteren Kuppel 2 sind Lampen 6 angeordnet, um die Substratscheibe auf Abscheidetemperatur zu erhitzen. Während des Abscheidens einer Schicht liegt die Substratscheibe 4 auf einem Suszeptor 5, der selbst von Suszeptor-Tragarmen getragen wird. Die Suszeptor-Tragarme sind Bestandteil einer Hub- und Rotationseinrichtung zum Heben und Drehen des Suszeptors und der Substratscheibe. Prozessgas wird über Gaszuleitungen und durch einen Gaseinlass 8 in die Vorrichtung 3 eingeleitet und durch einen Gasauslass 10 aus der Vorrichtung ausgeleitet. Die gezeigte Ausführungsform umfasst darüber hinaus einen weiteren Gaseinlass 9 und einen weiteren Gasauslass 11, um Spülgas durch den Bereich unter dem Suszeptor während des Vorgangs des Abscheidens der Schicht auf der Substratscheibe zu leiten.

### Ausführungsbeispiel:

Das Ausführungsbeispiel zeigt, dass bereits ein nützlicher Effekt zu beobachten ist, selbst wenn die Anwendung von beschichteten Bestandteilen aus Edelstahl auf die Anwendung beschichteter Gaszuleitungen und einer beschichteten Abgasleitung beschränkt wird. Auf Substratscheiben aus einkristallinem Silizium mit einem Durchmesser von 300 mm wurden in einer Vorrichtung vom Typ Centura^{®} von Applied Materials, Inc. eine epitaktische Schicht aus einkristallinem Silizium abgeschieden. Während einer Versuchsreihe waren die mit Prozessgas in Kontakt kommenden Flächen der Gaszuleitungen und der erste Meter der Abgasleitung (inklusive Faltenbalg und Konus) mit einer Schicht aus Dursan^{®} beschichtet, während einer zweiten Versuchsreihe mit Siliziumdioxid beschichtet und während einer dritten Versuchsreihe unbeschichtet im Originalzustand mit einer Oberfläche aus Edelstahl. Zu Beginn jeder Versuchsreihe befand sich die Vorrichtung in frisch gewartetem Zustand.

Nach der Abscheidung der epitaktischen Schicht wurde die Lebensdauer von Minoritätsladungsträgern mittels µPCD der Produktscheiben bestimmt.

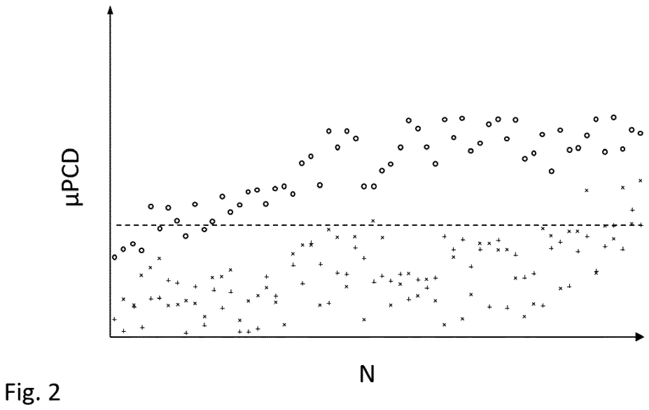

In Fig. 2 sind die gemessenen µPCD-Werte über der Anzahl N der gemessenen Substratscheiben mit abgeschiedener epitaktischer Schicht aufgetragen. Bei den erfindungsgemäß produzierten Substratscheiben mit epitaktischer Schicht wurden größere Lebensdauern gemessen und ein gesetzter Schwellwert (gestrichelte Linie) schneller erreicht, was den Schluss nahelegt, dass weniger Verunreinigungen wie Eisen freigesetzt und in der epitaktischen Schicht aufgenommen wurden.

## Patentansprüche

1. Vorrichtung zum Abscheiden einer Schicht aus Halbleitermaterial auf einer Substratscheibe, umfassend
einen Grundring zwischen einer oberen und einer unteren Kuppel;
einen Suszeptor als Träger der Substratscheibe während des Abscheidens der Schicht;
einen Gaseinlass und einen Gasauslass, eine Abgasleitung sowie Gaszuleitungen zum Leiten von Prozessgas über eine obere Seitenfläche der Substratscheibe;
ein Schlitzventil-Tunnel und eine Schlitzventil-Türe; und
eine Hub- und Rotationseinrichtung zum Heben und Drehen des Suszeptors und der Substratscheibe,
**dadurch gekennzeichnet, dass** ein oder mehrere Bestandteile der Vorrichtung, die aus Edelstahl bestehen von einer amorphen Schicht bedeckt sind, die Silizium und
Wasserstoff enthält.

2. Vorrichtung nach Anspruch 1, **dadurch gekennzeichnet, dass** die Bestandteile aus Edelstahl der Grundring, der Gaseinlass, der Gasauslass, die Gaszuleitungen, die Abgasleitung inklusive eines Faltenbalgs und eines Konus, der Schlitzventil-Tunnel, die Schlitzventil-Türe und die Hub- und Rotationseinrichtung sind.

3. Vorrichtung nach Anspruch 1 oder Anspruch 2, **dadurch gekennzeichnet, dass** sie als Einzelscheiben-Reaktor ausgeführt ist.

4. Vorrichtung nach einem der Ansprüche 1 bis 3, **dadurch gekennzeichnet, dass** sie zum Abscheiden einer epitaktischen Schicht auf der Substratscheibe unter Normaldruck ausgelegt ist.

5. Verfahren zum Abscheiden einer epitaktischen Schicht aus Halbleitermaterial auf einer Substratscheibe, **dadurch gekennzeichnet, dass**
die Substratscheibe in einer Vorrichtung nach einem der Ansprüche 1 bis 4 mit der epitaktischen Schicht beschichtet wird.
